# EUROPEAN PATENT SPECIFICATION

(11) **EP 3 513 202 B1**
(45) Date of publication and mention of the grant of the patent: **20.03.2024**
(21) Application number: 17822468.9
(22) Date of filing: 13.09.2017
(51) Int. Cl.: G01R 15/16, H01R 13/66

(54) **METHOD FOR OBTAINING A CAPACITIVE VOLTAGE SENSOR AND CAPACITIVE VOLTAGE SENSOR OBTAINED BY THIS METHOD**
VERFAHREN ZUR HERSTELLUNG EINES KAPAZITIVEN SPANNUNGSSENSORS UND NACH DIESEM VERFAHREN HERGESTELLTER KAPAZITIVER SPANNUNGSSENSOR
PROCÉDÉ D'OBTENTION DE CAPTEUR DE TENSION CAPACITIF ET CAPTEUR DE TENSION CAPACITIF OBTENU PAR CE PROCÉDÉ

(30) Priority: 14.09.2016 IT 201600092324
(43) Date of publication of application: 24.07.2019
(73) Proprietor: G & W Electric Company, Bolingbrook IL 60440 (US)
(72) Inventor: PERETTO, Lorenzo, I-45025 Fratta Polesine, Rovigo (IT); BAUER, Alberto, Dubai (AE)
(74) Representative: Kuhnen & Wacker Patent- und Rechtsanwaltsbüro PartG mbB
(86) International application number: PCT/IT2017/000194
(87) International publication number: WO 2018/051380

(56) References cited:
- EP-A1- 2 608 338
- EP-A1- 2 816 361
- EP-A1- 2 993 480
- WO-A1-2015/179285

## Description

### TECHNICAL FIELD

This invention relates to a method for obtaining a capacitive sensor and a capacitive sensor obtained by said method.

More particularly, but without limited intent, the present invention relates to a method of the above-mentioned type applicable to an electric current conductor device, in which said electrical current conductor device comprises a conductive body, at least one layer of insulating material placed overlaying with respect to said conductive body and at least one layer of semiconductive material placed overlaying with respect to said layer of insulating material.

### BACKGROUND OF INVENTION

At present in order to form a capacitive electrical voltage sensor, some components must be prepared and then some operations must be executed by using these components, that is to assembly these components.

More particularly, current methods for forming a voltage sensor have a number of drawbacks.

A first drawback is due to the fact that some components must be prepared to form the capacitive sensor.

A second drawback is due to the fact that the various components must be assembled together for forming the capacitive sensor.

A third drawback is due to the fact that difficult and laborious operations are required.

In addition, the current capacitive voltage sensors are expensive to realize as they are laborious to make and as they require the use of additional components.

Pertinent prior art is found in EP 2 993 480 A1, EP 2 608 338 A1, EP 2 816 361 A1 and WO 2015/179285 A1.

### DESCRIPTION OF THE INVENTION

The object of the present invention is to solve the aforementioned drawbacks.

To solve this problem the invention provides a method to obtain a capacitive voltage sensor by a conductor device of electrical current as defined in claim 1 and a capacitive voltage sensor as defined in claim 8. Further improvements are subject to the dependent claims.

### DESCRIPTION OF DRAWINGS

Further features and advantages of the present invention will be more evident from the following description of some of its preferred embodiments, here given merely by way of non-limiting example, with reference to the accompanying drawings in which:
Fig. 1 illustrates a current conducting device;
Figures 2, 3, 3A and 4 illustrate a first embodiment of the method of the present invention implemented on the device of Figure 1, a capacitive voltage sensor obtained by the method object of the present invention and/or a particular capacitive voltage sensor.

### Method - Preferred Forms of Implementation

With reference to the accompanying drawings, the method for obtaining a capacitive voltage sensor is particularly but not exclusively applicable to a generic current conductor 100, in which said electric current conductor device 100 extends along a longitudinal axis X, in which said conductor device 100 of electric current, substantially, comprises: a conductor body 110 which extends along a longitudinal axis X; at least one layer 120 of insulating material which extends along a longitudinal axis X placed overlying and preferably adhering with respect to said conductor body 110; and at least one layer 130 of semiconductive material which extends along a longitudinal axis X placed overlying and preferably adhering with respect to said layer 120 of insulating material.

Preferably but without restrictive intent, the conducting device 100 may be a conductive wire 100, in which the conducting body 110 is located in the center, and wherein the layer 120 of insulating material as well as the layer 130 of semiconducting material have a tubular shape.

With reference to the method object of the present invention it provides to form a first disconnected portion 131 of layer of semiconducting material by said layer 130 of semiconductive material.

Said first disconnected portion 131 of layer of semiconductive material is kept on and preferably adherent with respect to said layer 120 of insulating material and, more particularly, preferably, as described hereinafter, the inner face of this disconnected portion 131 is not detached with respect to the outer face of the layer 120 of insulating material.

Said first disconnected portion 131 of layer of semiconductive material is electrically disconnected with respect to the remaining layer 132 of semiconductive material and, therefore, a capacitive coupling is formed between the live conductor 110 (first armature of the coupling) and said first disconnected portion 131 (second armature of the coupling), in other words said first disconnected portion 131 of layer of semiconductive material performs the function of an electric field sensor.

Said first disconnected portion 131 of layer of semiconductive material is electrically insulated with respect to the remaining layer 132 of semiconductive material and, more particularly, electrically insulated in such a way as to guarantee said electrical insulation in correlation with the maximum voltages to be applied.

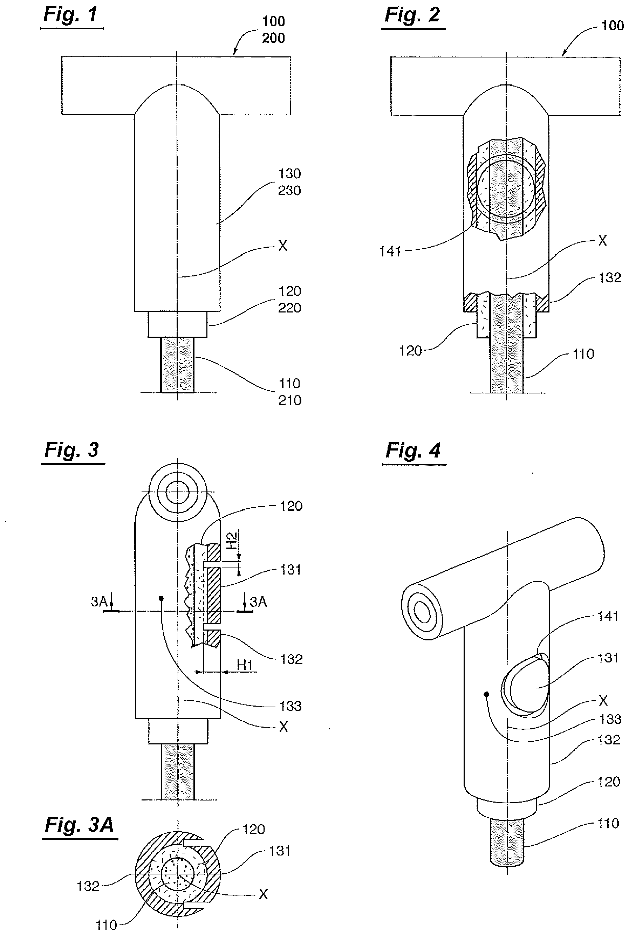

With particular reference to Figures 3 and 4, said first disconnected portion 131 has a shape and/or a size such that it does not interrupt the longitudinal axial continuity X for said layer 130 of semiconductive material 130 and, in this context, said first disconnected portion 131 of layer of semiconductive material has such a size able to maintain a second portion 133 of layer of semiconductive material to the side of the same first disconnected portion 131 , in which said second portion 133 is substantially able to maintain the axial continuity regarding the structure and/or to maintain the axial continuity regarding the electrical conductivity with reference to the layer 130 of semiconductive material, despite the fact that the first disconnected portion 131 has been formed.

Again with reference to the method object of the present invention, preferably with reference to the conductor device 100 of the electric current described above, it provides to execute a groove 141 having a closed-line path in the layer 130 of semiconductive material, in order to form through said layer 130 of semiconductive material a first disconnected portion 131 of layer of semiconductive material, in which said first disconnected portion 131 of layer of semiconductive material is kept overlying with respect to said layer of insulating material 120, in which said disconnected portion 131 of layer of semiconductive material layer is electrically disconnected with respect to the remaining layer 132 of semiconductive material, in which said disconnected portion 131 of layer of semiconductive material is electrically insulated with respect to the remaining layer 132 of semiconductive material, and in which said first disconnected portion 131 has a shape and/or a size such that it does not interrupt the longitudinal axial X continuity for said layer 130 of semiconducting material.

Again with reference to the method object of the present invention, preferably with reference to the conductor device 100 of electric current described above, it is executed a groove 141 having a closed-line path in the layer 130 of semiconductive material, in order to form through said layer 130 of semiconductive material a first disconnected portion 131 of layer of semiconductive material and a second portion 133 of layer of semiconductive material, in which said first disconnected portion 131 of layer of semiconductive material is kept overlying with respect to said layer of insulating material 120, in which said first disconnected portion 131 of semiconductive material is electrically disconnected with respect to the remaining layer 132 of semiconductive material, in which said first disconnected portion 131 of semiconductive material is electrically insulated with respect to the remaining layer 132 of semiconductive material, in which said second portion 133 maintains the axial structural continuity (a partial axial continuity with respect to the previous continuity) with respect to the third layer 130 of semiconductive material and/or it maintains the conductive axial continuity in relation to the third layer 130 of the semiconductive material.

With reference to the method above-described, it is clear that it enables to obtain a capacitive voltage sensor in a quickly manner, without execution of laborious and/or complicated operations, without the use of additional components and, in addition, while maintaining the structural axial continuity and the electric conductive axial continuity with reference to the third layer 130 of layer of semiconducting material.

In accordance with the method object of the present invention, it is possible to detect the presence or non-presence of electrical voltage in said first disconnected portion 131 of layer of semiconductive material, in order to determine the presence or non-presence of voltage for the conductor 110.

In accordance with the method object of the present invention, the value V_131 of the electrical voltage regarding said first disconnected portion 131 of layer of semiconductive material may be detected by means of any device connected/associated with said disconnected portion 131 and, on the base of the value of the electrical voltage detected in said first disconnected portion 131 of layer of semiconducting material, it is possible to process said value in order to estimate the voltage of the conductor body 110.

### Method - Detailed Description Fig. 2, 3, 3A and 4

With reference to a first preferred embodiment, see Figs. 2, 3, 3A and 4, said first disconnected portion 131 is a layer of semiconductive material having a flat geometric shape delimited by a closed line, such as a circular shape as illustrated but, in this context, it is to be understood that said first disconnected portion 131 may also assume other shapes such as, for example, a shape as an ellipse and/or a polygonal shape and/or other types of shapes without getting out from the concepts of exclusive protected by the present invention.

In this context, preferably, one or more grooves 141 are executed in the layer 130 of semiconductive material, in which said one or more grooves 141 are able to form the perimeter of said disconnected portion 131 of layer of semiconductive material.

More in particular, said one or more grooves 141 have a given depth H1, in which said given depth H1 has a value equal to or greater with respect to the minimum depth necessary to obtain and ensure the electrical disconnection and the electrical insulation between said disconnected portion 131 of layer of semiconductive material with respect to the remaining layer 132 of semiconductive material.

Furthermore, said one or more electrical disconnecting grooves 141 have a given width H2, in which said given width H2 has a value equal to or greater with respect to the minimum width which is necessary in order to obtain and ensure the electrical disconnection and the electrical insulation between said disconnected portion 131 of layer of semiconductive material and the remaining layer 132 of semiconductive material.

### Method - Further Layers

With reference to the above method, if desirable, a first additional layer of electrically insulating material can be applied above and/or around said disconnected portion 131 of semiconductive material, in order to cover said first disconnected portion 131 of layer of semiconductive material and/or in order to cover the relevant groove/grooves 141, in such a way as to prevent electrical connections between said first disconnected portion 131 of semiconductive material and the remaining layer 132 of semiconductive material due to external agents which may fit within said grooves 141.

Again with reference to the above method, if desirable, a second additional layer of electrically conductive material can be applied in proximity of said disconnected portion 131 of layer of semiconductive material and over said first additional layer of electrically insulating material, in order to screen said disconnected portion 131 of layer of semiconductive material with respect to the surrounding electric fields. In this context, preferably, said second additional layer of electrically conductive material is electrically connected with the remaining layer 132 of semiconductive material and/or it is electrically connected to the ground.

### Sensor Obtained By The Method/Methods

With reference to the method above described, it is able to obtain a capacitive sensor using an electrical conducting device 100 and, therefore, the present invention also protects a capacitive sensor obtained by the above mentioned method.

### Capacitive Sensor

Furthermore, the present invention also protects a capacitive voltage sensor regardless of the above method.

Referring to Figures from 2 to 4, the present invention also protects a capacitive voltage sensor comprising a conductor body 110 which extends along a longitudinal axis X, at least one layer 120 of insulating material which extends along a longitudinal axis X overlying and preferably adhering to said conductive body 110 extending along said longitudinal axis X and at least one layer 130 of semiconductive material which extends along a longitudinal axis X and overlying 0 and preferably adhering said layer 120 of insulating material, in which said capacitive sensor comprises a first portion 131 of layer of semiconductive material 130, in which said first portion 131 is electrically disconnected and electrically insulated with respect to the layer 130 of semiconductive material, in which said first portion 131 has a shape and/or a size such that it does not 5 interrupt the longitudinal axial X continuity about said layer 130 of semiconducting material 130, in which preferably the layer 120 of insulating material and the layer 130 of semiconducting material have a tubular shape.

More in particular, said capacitive sensor comprises a first portion 131 of layer of semiconductive material and a second portion 133 of layer of semiconductive 0 material, in which said first portion 131 of layer of semiconductive material is electrically disconnected and electrically insulated with respect to the layer 130 of semiconductive material, in which said second portion 133 of layer of semiconductive material is able to form a longitudinal axial electrical conductive continuity for the layer 130 of the semiconductive material in the axial region in which is present said first portion 131.

This second portion 133 of semiconductive material layer 130 may also form a longitudinal axial electrical conductive continuity for the semiconductive material layer 130.

In the preferred illustrated embodiment, said first portion 131 of semiconductive layer is preferably positioned transversely to the side of the second portion 133 of the semiconductive material layer 130, and preferably the same first portion 131 has a shape like a two-dimensional geometrical figure bounded by a closed line.

Again with reference to Figures from 2 to 4, said capacitive sensor preferably comprises one or more grooves 141 for forming the perimeter of said first portion 131 of layer of semiconductive material.

Said one or more grooves 141 have a given depth H1, in which said given depth H1 has a value equal to or greater with respect to the minimum depth necessary to obtain and ensure the electrical disconnection and the electrical insulation between said first disconnected portion 131 of the layer of semiconductive material with respect to the remaining layer 132 of semiconductive material.

Said one or more grooves 141 have a given width H2, in which said given width H2 has a value equal to or greater with respect to the minimum width which is necessary in order to obtain and ensure the electrical disconnection and the electrical insulation between said disconnected portion 131 of layer of semiconductive material and the remaining layer 132 of semiconductive material. Capacitive Sensor - Additional Layers

With reference to the capacitance sensor above described, it may further comprise a first additional layer of electrically insulating material applied above and around said disconnected portion 131 of semiconductive material in order to cover said layer 131 and the groove/grooves 141.

Again with reference to the capacitive sensor above described, it can further comprise a second additional layer of electrically conductive material applied in proximity of said first disconnected portion 131 of semiconductive material, and preferably, paced over said first additional layer of electrically insulating material, in order to screen said disconnected portion 131 of layer of semiconductive material with respect to the surrounding electric fields.

Said second additional layer of electrically conductive material is preferably electrically connected with the remaining layer 132/133 of semiconductive material and, if desirable, it can be electrically connected to the ground.

The description of the method and of the capacitive sensor are given purely by ways of example and without restrictive intent and, therefore, said method and said capacitive sensor can clearly be subject to all modifications or variations within the scope of the following claims.

## Claims

1. Method to obtain a capacitive voltage sensor by a conductor device (100) of electrical current, in which said conductor device (100) extends along a longitudinal axis (X) and comprises:
- providing a conductor body (110) which extends along the longitudinal axis (X),
- providing at least one layer (120) of insulating material which extends along the longitudinal axis (X) and overlying said conductor body (110),
- providing at least one layer (130) of semiconductive material which extends along the longitudinal axis (X) and overlying said layer (120) of insulating material,
wherein
a groove (141) having a closed-line path is executed in the layer (130) of semiconductive material in order to form from said layer (130) of semiconductive material a first portion (131) and a second portion (133),
said first portion (131) is electrically disconnected and electrically isolated with respect to said second portion (133),
said first portion (131) overlies said layer of insulating material (120),
**characterised in that**
said second portion (133) maintains conductive axial continuity along said layer (130) of the semiconductive material, and
said first portion (131) has a shape like a two-dimensional geometrical figure bounded by the closed-line path of the groove (141).

2. Method according to claim 1, **characterized by** the fact that said two-dimensional geometrical figure is a circle.

3. Method according to one of the preceding claims, **characterized by** the fact that one or more grooves (141) are executed in the layer (130) of semiconductive material and are able to form the perimeter of said first portion (131).

4. Method according to claim 3, **characterized by** the fact said one or more grooves (141) have a given depth (H1) which has a value equal to or greater with respect to the minimum depth necessary to obtain and ensure the electrical disconnection and the electrical insulation between said first portion (131) and said second portion (133).

5. Method according to claim 3 or 4, **characterized by** the fact that said one or more grooves (141) have a given width (H2) which has a value equal to or greater with respect to the minimum width which is necessary to obtain and ensure the electrical disconnection and the electrical insulation between said first portion (131) and said second portion (133).

6. Method according to one of the preceding claims **characterized by** the fact that a first additional layer of electrically insulating material is applied above and around said first portion (131) in order to cover said first portion (131) and the groove or grooves (141).

7. Method according to claim 6, **characterized by** the fact that a second additional layer of electrically conductive material is applied in proximity of said first portion (131) and over said first additional layer of electrically insulating material in order to screen said first portion (131) with respect to the surrounding electric fields.

8. Capacitive voltage sensor comprising:
- a conductor body (110) which extends along a longitudinal axis (X),
- at least one layer (120) of insulating material which extends along the longitudinal axis (X) and overlying said conductor body (110),
- at least one layer (130) of semiconductive material which extends along the longitudinal axis (X) and overlying said layer (120) of insulating material,
wherein
- the layer (130) of semiconductive material includes a first portion (131) and a second portion (133),
said first portion (131) is electrically disconnected and electrically isolated with respect to the second portion (133),
**characterised in that**
said second portion (133) maintains longitudinal axial electrical conductive continuity along the layer (130) of the semiconductive material, and
said first portion (131) has a shape like a two-dimensional geometrical figure bounded by the closed-line path of the groove (141).

9. Sensor according to claim 8, **characterized by** the fact that said first portion (131) of said layer of semiconductive material is positioned transversely to the side with respect to the second portion (133) of said layer of semiconductive material (130).

10. Sensor according to Claim 8 or 9, **characterized by** the fact that said two-dimensional geometrical figure is a circle.

11. Sensor according to one of claims 8 to 10, **characterized by** the fact to comprise one or more grooves (141) which are able to form the perimeter of said first portion (131) of layer of semiconductive material.

12. Sensor according to claim 11, **characterized by** the fact said one or more grooves (141) have a given depth (H1) which has a value equal to or greater with respect to the minimum depth necessary to obtain and ensure the electrical disconnection and the electrical insulation between said first portion (131) with respect to said second portion (133).

13. Sensor according to claim 11 or 12, **characterized by** the fact that said one or more grooves (141) have a given width (H2) which has a value equal to or greater with respect to the minimum width which is necessary in order to obtain and ensure the electrical disconnection and the electrical insulation between said first portion (131) and said second portion (133).

## Patentansprüche

1. Verfahren zum Erhalten eines kapazitiven Spannungssensors durch eine Leitervorrichtung (100) für elektrischen Strom, wobei die Leitervorrichtung (100) entlang einer Längsachse (X) verläuft, mit folgenden Schritten:
- Bereitstellen eines Leitungskörpers (110), der entlang der Längsachse (X) verläuft,
- Bereitstellen zumindest einer Schicht (120) von Isoliermaterial, die entlang der Längsachse (X) verläuft und auf dem Leitungskörper (110) aufliegt,
- Bereitstellen zumindest einer Schicht (130) von Halbleitermaterial, die entlang der Längsachse (X) verläuft und auf der Schicht (120) von Isoliermaterial aufliegt,
wobei
eine Nut (141) mit einem geschlossenen Leitungspfad in der Schicht (130) des Halbleitermaterials ausgeführt ist, um einen ersten Abschnitt (131) und einen zweiten Abschnitt (133) von der Schicht (130) des Halbleitermaterials zu bilden,
der erste Abschnitt (131) im Verhältnis zu dem zweiten Abschnitt (133) elektrisch getrennt und elektrisch isoliert ist,
der erste Abschnitt (131) auf der Schicht des Isoliermaterials (120) aufliegt,
**dadurch gekennzeichnet, dass**
der zweite Abschnitt (133) entlang der Schicht (130) des Halbleitermaterials eine leitende axiale Kontinuität aufrechterhält, und
der erste Abschnitt (131) eine Form wie eine zweidimensionale geometrische Figur aufweist, die von dem geschlossenen Leitungspfad der Nut (141) begrenzt ist.

2. Verfahren nach Anspruch 1, **dadurch gekennzeichnet, dass** die zweidimensionale geometrische Figur ein Kreis ist.

3. Verfahren nach einem der vorgenannten Ansprüche, **dadurch gekennzeichnet, dass** eine oder mehrere Nuten (141) in der Schicht (130) des Halbleitermaterials ausgeführt sind und in der Lage sind, den Rand des ersten Abschnitts (131) zu bilden.

4. Verfahren nach Anspruch 3, **dadurch gekennzeichnet, dass** die eine oder mehreren Nuten (141) eine bestimmte Tiefe (H1) aufweisen, die einen Wert aufweist, der im Verhältnis zu der minimalen Tiefe, die nötig ist, um die elektrische Trennung und die elektrische Isolierung zwischen dem ersten Abschnitt (131) und dem zweiten Abschnitt (133) zu erhalten und sicherzustellen, gleich oder größer ist.

5. Verfahren nach Anspruch 3 oder 4, **dadurch gekennzeichnet, dass** die eine oder mehreren Nuten (141) eine bestimmte Breite (H2) aufweisen, die einen Wert aufweist, der im Verhältnis zu der minimalen Tiefe, die nötig ist, um die elektrische Trennung und die elektrische Isolierung zwischen dem ersten Abschnitt (131) und dem zweiten Abschnitt (133) zu erhalten und sicherzustellen, gleich oder größer ist.

6. Verfahren nach einem der vorgenannten Ansprüche, **dadurch gekennzeichnet, dass** eine erste zusätzliche Schicht von elektrischem Isoliermaterial über und um den ersten Abschnitt (131) herum aufgebracht ist, um den ersten Abschnitt (131) und die Nut oder Nuten (141) abzudecken.

7. Verfahren nach Anspruch 6, **dadurch gekennzeichnet, dass** eine zweite zusätzliche Schicht von elektrisch leitendem Material in der Nähe des ersten Abschnitts (131) und über der ersten zusätzlichen Schicht elektrisch leitenden Materials aufgebracht ist, um den ersten Abschnitt (131) im Verhältnis zu den umgebenden elektrischen Feldern abzuschirmen.

8. Kapazitiver Spannungssensor, mit:
- einem Leitungskörper (110), der entlang einer Längsachse (X) verläuft,
- zumindest einer Schicht (120) von Isoliermaterial, die entlang der Längsachse (X) verläuft und auf dem Leitungskörper (110) aufliegt,
- zumindest einer Schicht (130) von Halbleitermaterial, die entlang der Längsachse (X) verläuft und auf der Schicht (120) von Isoliermaterial aufliegt,
wobei
die Schicht (130) des Halbleitermaterials einen ersten Abschnitt (131) und einen zweiten Abschnitt (133) beinhaltet,
der erste Abschnitt (131) im Verhältnis zu dem zweiten Abschnitt (133) elektrisch getrennt und elektrisch isoliert ist,
**dadurch gekennzeichnet, dass**
der zweite Abschnitt (133) entlang der Schicht (130) des Halbleitermaterials eine elektrisch leitende longitudinal-axiale Kontinuität aufrechterhält, und
der erste Abschnitt (131) eine Form wie eine zweidimensionale geometrische Figur aufweist, die von dem geschlossenen Leitungspfad der Nut (141) begrenzt ist.

9. Sensor nach Anspruch 8, **dadurch gekennzeichnet, dass** der erste Abschnitt (131) der Schicht des Halbleitermaterials im Verhältnis zu dem zweiten Abschnitt (133) der Schicht des Halbleitermaterials (130) transversal zu der Seite positioniert ist.

10. Sensor nach Anspruch 8 oder 9, **dadurch gekennzeichnet, dass** die zweidimensionale geometrische Figur ein Kreis ist.

11. Sensor nach einem der Ansprüche 8 bis 10, **dadurch gekennzeichnet, dass** er eine oder mehrere Nuten (141) aufweist, die in der Lage sind, den Rand des ersten Abschnitts (131) der Schicht des Halbleitermaterials zu bilden.

12. Sensor nach Anspruch 11, **dadurch gekennzeichnet, dass** die eine oder mehreren Nuten (141) eine bestimmte Tiefe (H1) aufweisen, die einen Wert aufweist, der im Verhältnis zu der minimalen Tiefe, die nötig ist, um die elektrische Trennung und die elektrische Isolierung zwischen dem ersten Abschnitt (131) im Verhältnis zu dem zweiten Abschnitt (133) zu erhalten und sicherzustellen, gleich oder größer ist.

13. Sensor nach Anspruch 11 oder 12, **dadurch gekennzeichnet, dass** die eine oder mehreren Nuten (141) eine bestimmte Breite (H2) aufweisen, die einen Wert aufweist, der im Verhältnis zu der minimalen Tiefe, die nötig ist, um die elektrische Trennung und die elektrische Isolierung zwischen dem ersten Abschnitt (131) und dem zweiten Abschnitt (133) zu erhalten und sicherzustellen, gleich oder größer ist.

## Revendications

1. Procédé pour réaliser un capteur de tension capacitif par un dispositif conducteur (100) de courant électrique, ledit dispositif conducteur (100) s'étendant le long d'un axe longitudinal (X), consistant à :
- fournir un corps conducteur (110) qui s'étend le long de l'axe longitudinal (X) ;
- fournir au moins une couche (120) de matériau isolant qui s'étend le long de l'axe longitudinal (X) et recouvre ledit corps conducteur (110) ;
- fournir au moins une couche (130) de matériau semi-conducteur qui s'étend le long de l'axe longitudinal (X) et recouvre ladite couche (120) de matériau isolant,
dans lequel
une rainure (141) ayant une trajectoire en ligne fermée est ménagée dans la couche (130) de matériau semi-conducteur afin de former une première portion (131) et une deuxième portion (133) à partir ladite couche (130) de matériau semi-conducteur,
ladite première portion (131) est électriquement déconnectée et électriquement isolée par rapport à ladite deuxième portion (133),
ladite première partie (131) recouvre ladite couche (120) de matériau isolant,
**caractérisé en ce que**
ladite deuxième portion (133) maintient une continuité axiale de conduction le long de ladite couche (130) de matériau semi-conducteur, et
ladite première portion (131) a la forme d'une figure géométrique bidimensionnelle délimitée par la trajectoire en ligne fermée de la rainure (141).

2. Procédé selon la revendication 1,
**caractérisé en ce que** ladite figure géométrique bidimensionnelle est un cercle.

3. Procédé selon l'une des revendications précédentes,
**caractérisé en ce qu'**une ou plusieurs rainures (141) sont ménagées dans la couche (130) de matériau semi-conducteur et sont en mesure de former le périmètre de ladite première portion (131).

4. Procédé selon la revendication 3,
**caractérisé en ce que** ladite ou lesdites plusieurs rainures (141) ont une profondeur donnée (H1) qui a une valeur égale ou supérieure à la profondeur minimale nécessaire pour obtenir et assurer la déconnexion électrique et l'isolation électrique entre ladite première portion (131) et ladite deuxième portion (133).

5. Procédé selon la revendication 3 ou 4,
**caractérisé en ce que** ladite ou lesdites plusieurs rainures (141) ont une largeur donnée (H2) qui a une valeur égale ou supérieure à la largeur minimale qui est nécessaire pour obtenir et assurer la déconnexion électrique et l'isolation électrique entre ladite première portion (131) et ladite deuxième portion (133).

6. Procédé selon l'une des revendications précédentes,
**caractérisé en ce qu'**une première couche supplémentaire de matériau électriquement isolant est appliquée au-dessus et autour de ladite première portion (131) afin de recouvrir ladite première portion (131) et la rainure ou les rainures (141).

7. Procédé selon la revendication 6,
**caractérisé en ce qu'**une deuxième couche supplémentaire de matériau électriquement conducteur est appliquée à proximité de ladite première portion (131) et par-dessus ladite première couche supplémentaire de matériau électriquement isolant afin de protéger ladite première portion (131) par rapport aux champs électriques environnants.

8. Capteur de tension capacitif comprenant :
- un corps conducteur (110) qui s'étend le long d'un axe longitudinal (X) ;
- au moins une couche (120) de matériau isolant qui s'étend le long de l'axe longitudinal (X) et recouvre ledit corps conducteur (110) ;
- au moins une couche (130) de matériau semi-conducteur qui s'étend le long de l'axe longitudinal (X) et recouvre ladite couche (120) de matériau isolant ;
dans lequel
la couche (130) de matériau semi-conducteur comprend une première portion (131) et une deuxième portion (133),
ladite première portion (131) est électriquement déconnectée et électriquement isolée par rapport à la deuxième portion (133),
**caractérisé en ce que**
ladite deuxième portion (133) maintient une continuité longitudinale axiale de conduction électrique le long de la couche (130) de matériau semi-conducteur, et
ladite première portion (131) a la forme d'une figure géométrique bidimensionnelle délimitée par la trajectoire en ligne fermée de la rainure (141).

9. Capteur selon la revendication 8,
**caractérisé en ce que** ladite première portion (131) de ladite couche de matériau semi-conducteur est positionnée transversalement sur le côté par rapport à la deuxième portion (133) de ladite couche (130) de matériau semi-conducteur.

10. Capteur selon la revendication 8 ou 9,
**caractérisé en ce que** ladite figure géométrique bidimensionnelle est un cercle.

11. Capteur selon l'une des revendications 8 à 10,
**caractérisé en ce qu'**il comprend une ou plusieurs rainures (141) qui sont en mesure de former le périmètre de ladite première portion (131) de la couche de matériau semi-conducteur.

12. Capteur selon la revendication 11,
**caractérisé en ce que** ladite ou lesdites plusieurs rainures (141) ont une profondeur donnée (H1) qui a une valeur égale ou supérieure à la profondeur minimale nécessaire pour obtenir et assurer la déconnexion électrique et l'isolation électrique entre ladite première portion (131) et ladite deuxième portion (133).

13. Capteur selon la revendication 11 ou 12,
**caractérisé en ce que** ladite ou lesdites plusieurs rainures (141) ont une largeur donnée (H2) qui a une valeur égale ou supérieure à la largeur minimale qui est nécessaire pour obtenir et assurer la déconnexion électrique et l'isolation électrique entre ladite première portion (131) et ladite deuxième portion (133).
